(19) Europäisches Patentamt
European Patent Office
Office européen des brevets

(11) **EP 2 567 245 B1**

(12) **FASCICULE DE BREVET EUROPEEN**

(45) Date de publication et mention
de la délivrance du brevet:
**23.02.2022 Bulletin 2022/08**

(21) Numéro de dépôt: **11723677.8**

(22) Date de dépôt: **03.05.2011**

(51) Classification Internationale des Brevets (IPC):
**G01Q 60/30** (2010.01)   **G01R 15/08** (2006.01)
**G01R 27/20** (2006.01)

(52) Classification Coopérative des Brevets (CPC):
**B82Y 35/00; G01Q 60/30**

(86) Numéro de dépôt international:
**PCT/IB2011/051951**

(87) Numéro de publication internationale:
**WO 2011/138738 (10.11.2011 Gazette 2011/45)**

(54) **APPAREIL DE MESURE DE LA RESISTANCE ELECTRIQUE LOCALE D'UNE SURFACE**

VORRICHTUNG ZUM MESSEN DES LOKALEN ELEKTRISCHEN WIDERSTAND EINER OBERFLÄCHE

DEVICE FOR MEASURING THE LOCAL ELECTRICAL RESISTANCE OF A SURFACE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.05.2010 FR 1001940**

(43) Date de publication de la demande:
**13.03.2013 Bulletin 2013/11**

(73) Titulaires:
• **Centre National de la Recherche Scientifique**
**75016 Paris (FR)**
• **Ecole Superieure d'electricite**
**91192 Gif Sur Yvette Cedex (FR)**

(72) Inventeurs:
• **SCHNEEGANS, Olivier**
**F-92160 Antony (FR)**
• **CHRETIEN, Pascal**
**F-78140 Velizy Villacoublay (FR)**
• **HOUZE, Frédéric**
**F-78460 Chevreuse (FR)**

(74) Mandataire: **Marks & Clerk France**
**Immeuble "Visium"**
**22, avenue Aristide Briand**
**94117 Arcueil Cedex (FR)**

(56) Documents cités:
**US-B1- 6 612 161**

• **"Imaging the local electrical properties of metal surfaces by atomic force microscopy with conducting probes", APPLIED PHYSICS LETTERS, AIP, AMERICAN INSTITUTE OF PHYSICS, MELVILLE, NY, US, vol. 69, no. 13, 23 septembre 1996 (1996-09-23), pages 1975-1977, XP012016199, ISSN: 0003-6951, DOI: DOI:10.1063/1.117179**
• **DICKINSON J T ET AL: "THE USE OF SCANNING CONDUCTION MICROSCOPY TO PROBE ABRASION OF INSULATING THIN FILMS", REVIEW OF SCIENTIFIC INSTRUMENTS, AIP, MELVILLE, NY, US, vol. 66, no. 7, 1 juillet 1995 (1995-07-01), pages 3802-3806, XP000524274, ISSN: 0034-6748, DOI: DOI:10.1063/1.1145441**
• **Anonymous: "Potentiometer - Wikipedia", , 30 December 2016 (2016-12-30), XP055342078, Retrieved from the Internet: URL:https://en.wikipedia.org/wiki/Potentiometer [retrieved on 2017-02-03]**

Remarques:
Le dossier contient des informations techniques présentées postérieurement au dépôt de la demande et ne figurant pas dans le présent fascicule.

**Description**

L'invention porte sur un appareil permettant de mesurer la résistance électrique locale d'une surface. L'appareil de l'invention se caractérise par sa grande dynamique de mesure, pouvant s'étendre sur 10 décades ou plus, ainsi que par sa vitesse d'acquisition, qui permet de réaliser des « images de résistance » de la surface étudiée, pouvant être couplées à des images topographiques, notamment lorsque cet appareil est associé à un microscope à force atomique ou à un profilomètre mécanique.

Il est connu de modifier un microscope à force atomique pour permettre la mesure de la résistance (ou conductivité) électrique locale de la surface d'un échantillon. Cette technique utilise un microscope à force atomique fonctionnant en mode à contact, pourvu d'une pointe conductrice, et un générateur de tension permettant d'appliquer une différence de potentiel entre l'échantillon et la pointe. Une mesure du courant qui circule à travers la pointe permet de déterminer la résistance locale de la surface au point de contact. Ainsi, une « image de courant » (ou, ce qui est équivalent, de résistance) est acquise en même temps que l'image topographique fournie par la microscopie à force atomique conventionnelle. Un exemple de réalisation a été proposé en 1995 par J.T. Dickinson et al. (Rev. Sci. Instrum. 66 (7) 3802) par la mise en oeuvre d'un électromètre (Keithley™ 602) dont la sortie est amplifiée à l'aide d'un amplificateur différentiel (Tektronix™ 3A9), pour couvrir une gamme de courant du nA au µA.

Cette technique est utile pour caractériser des matériaux, des soudures, des contacts électriques, etc. Généralement, ces applications nécessitent une dynamique de mesure très large, s'étendant sur plusieurs décades (au moins 6, mais souvent plus). En outre, chaque mesure individuelle doit être effectuée en un temps court (de l'ordre des millisecondes) pour permettre l'acquisition en un temps raisonnable d'images de résistance présentant une bonne résolution.

Pour élargir la gamme de valeurs de résistance de contact mesurables, il est connu d'effectuer une compression de dynamique à l'aide d'un amplificateur logarithmique. Cette solution n'est pas satisfaisante, car les amplificateurs logarithmiques sont difficiles à calibrer, ce qui dégrade la précision de la mesure, notamment pour la mesure de très faibles courants (inférieurs ou égaux à 1 pA), associés à des valeurs élevées de la résistance de contact. En outre, la compression de dynamique assurée par les amplificateurs logarithmiques reste limitée, comme le montre le dispositif proposé en 1996 par F. Houzé et al.(Appl. Phys. Lett. 69 (13) 1975), qui couvre 5 décades. Pour atteindre, par exemple, 10 décades, il est possible d'avoir recours à des changements de calibre, qui introduisent des retards.

Une autre solution consiste à utiliser un amplificateur à transimpédance (convertisseur courant-tension) à gain variable. L'inconvénient de cette solution est que, pour mesurer des plages étendues de valeurs de résistance, il est nécessaire d'effectuer un nombre important de changements de gain, ce qui prend un temps non négligeable, pendant lequel on ne peut pas effectuer de mesure.

En outre, tant les amplificateurs logarithmiques que les amplificateurs à transimpédance sont des circuits complexes, difficiles à mettre en œuvre surtout lorsque l'on souhaite des performances élevées en termes de bruit, de dérives, d'impédance d'entrée, etc., ce qui est le cas lorsque, comme en l'espèce, on souhaite effectuer des mesures très précises avec une dynamique aussi grande que possible.

Le document US 6,871,559 divulgue un appareil de mesure de la résistance électrique locale d'une surface basé sur un microscope à force atomique modifié. Le circuit de mesure de cet appareil est basé sur un pont diviseur de tension ; l'utilisation d'un amplificateur logarithmique de courant est envisagée pour améliorer la résolution de mesure.

L'invention vise à remédier aux inconvénients de l'art antérieur en procurant un appareil de mesure de la résistance électrique locale d'une surface présentant une dynamique de mesure extrêmement large (pouvant dans certains cas atteindre 10, voire 12 décades ou plus) et un temps d'acquisition réduit (typiquement inférieur à 1ms), tout en étant simple et facile à calibrer de manière très précise.

Conformément à l'invention un tel but est atteint par un appareil de mesure de la résistance électrique locale d'une surface selon la revendication 1, comprenant : une source de tension continue pour appliquer une tension de polarisation à un échantillon à caractériser ; un circuit de mesure, connecté à une sonde conductrice susceptible d'entrer en contact avec une surface dudit échantillon, pour générer un signal représentatif d'une résistance de contact entre ladite sonde conductrice et ladite surface de l'échantillon ; et un dispositif de commande pour piloter ledit circuit de mesure ; où ledit circuit de mesure comprend : un dipôle résistif de mesure présentant une résistance variable, connecté entre ladite sonde conductrice et une masse du circuit ; et une unité de calcul pour générer ledit signal représentatif d'une résistance de contact entre ladite sonde conductrice et ladite surface de l'échantillon en fonction d'une tension aux bornes dudit dipôle résistif de mesure.

La résistance de contact (à mesurer) et le dipôle résistif de mesure (connu) forment un diviseur de tension. Il est simple de démontrer que la tension aux bornes du dipôle de mesure est une fonction non-linéaire de la résistance de contact. Le diviseur de tension permet donc de réaliser, d'une manière extrêmement simple, une compression de dynamique. En changeant la résistance du dipôle de mesure, on change la fonction non-linéaire de compression de dynamique réalisée par le diviseur. Cela permet d'étendre la dynamique de mesure.

Ledit dipôle résistif de mesure présente une résistance variable par paliers. Il comprend une pluralité de résistances de mesure de valeurs décroissantes, dont au moins une peut être connectée ou déconnectée sélectivement entre ladite pointe conductrice et la masse. La connexion/déconnexion d'une résistance peut être effectuée très rapidement, et n'a donc presque pas d'impact sur le temps d'acquisition. En variante, la résistance du dipôle résistif de mesure peut varier de manière continue.

Ledit dispositif de commande est adapté pour modifier la valeur de résistance dudit dipôle résistif en fonction d'une valeur mesurée préalablement de ladite résistance de contact, de manière à adapter la gamme de mesure de l'appareil à la résistance à mesurer. Il est adapté pour modifier la valeur de résistance dudit dipôle résistif selon une loi de commande avec hystérésis.

L'appareil peut comprendre également une résistance de calibrage pouvant être connectée ou déconnectée en parallèle à l'ensemble constitué par ledit échantillon et ladite pointe conductrice. Avantageusement, ladite résistance de calibrage peut présenter une résistance inférieure d'au moins un facteur 10 à la valeur minimale de résistance dudit dipôle résistif de mesure.

Ledit dispositif de commande peut être adapté pour : connecter ladite résistance de calibrage en parallèle de ladite sonde conductrice, maintenue à l'écart de toute surface conductrice, et mesurer la différence de potentiel aux bornes du dipôle résistif de mesure ; déconnecter ladite résistance de calibrage alors que ladite sonde conductrice est toujours maintenue à l'écart de toute surface conductrice, et mesurer la différence de potentiel aux bornes du dipôle résistif de mesure pour toutes les valeurs de résistance de ce dernier ; et calibrer ledit circuit de mesure à l'aide des valeurs de différence de potentiel mesurées. Le calibrage du circuit de mesure peut donc se faire de manière très simple.

L'unité de calcul peut être adaptée pour calculer le logarithme de ladite résistance de contact en fonction de la tension aux bornes du dipôle résistif de mesure. En effet, le plus souvent les images de résistance sont représentées à l'échelle logarithmique. Cela nécessite l'inversion de la fonction non-linéaire de compression réalisée par le diviseur de tension, la détermination de la valeur de la résistance de contact et le calcul de son logarithme (le plus souvent décimal). Ces opérations peuvent être réalisées très simplement par un circuit numérique dédié ou un ordinateur.

Ladite source de tension continue peut être une source de tension ajustable. Dans ce cas, dans un mode particulier de réalisation de l'invention, ledit dispositif de commande peut être adapté pour piloter ladite source de tension continue de manière à maintenir constante la différence de potentiel entre ledit échantillon et ladite sonde conductrice, indépendamment de la valeur de ladite résistance de contact.

La différence de potentiel aux bornes du dipôle résistif de mesure peut être lue par un amplificateur à haute impédance d'entrée présentant une réaction positive à travers un condensateur, de manière à compenser des capacités parasites du circuit de mesure.

L'appareil peut comporter également une sonde conductrice connectée audit circuit de mesure ; cette sonde peut être choisie parmi une pointe de microscope à force atomique, un stylet de profilomètre et d'un pion de tribomètre. Cette liste n'est pas limitative.

L'appareil peut comporter également un deuxième dispositif de pilotage pour piloter un actionneur induisant un déplacement de la sonde conductrice par rapport à la surface de l'échantillon, et pour recevoir dudit circuit de mesure ledit signal représentatif d'une résistance de contact, de manière à acquérir simultanément une image topographique et une image de résistance locale de ladite surface.

D'autres caractéristiques, détails et avantages de l'invention ressortiront à la lecture de la description faite en référence aux dessins annexés donnés à titre d'exemple et qui représentent, respectivement :

- La figure 1, un schéma d'un appareil selon un mode de réalisation de l'invention ;
- La figure 2, un graphique de la fonction de compression de dynamique réalisée par le diviseur de tension ;
- Les figures 3 et 4, deux graphiques illustrant la dépendance de l'incertitude de mesure de la valeur de la résistance de contact ;
- La figure 5, un organigramme du programme de pilotage du circuit de mesure de l'appareil de la figure 2 ;
- La figure 6A, la loi de commande avec hystérésis utilisée pour effectuer automatiquement le changement de résistance du dipôle résistif de mesure ;
- La figure 6B, un graphique de la tension aux bornes de la résistance de contact à mesurer en fonction de la valeur de ladite résistance; et
- La figure 7, un circuit permettant d'assurer une différence de potentiel constante entre l'échantillon et la pointe conductrice.

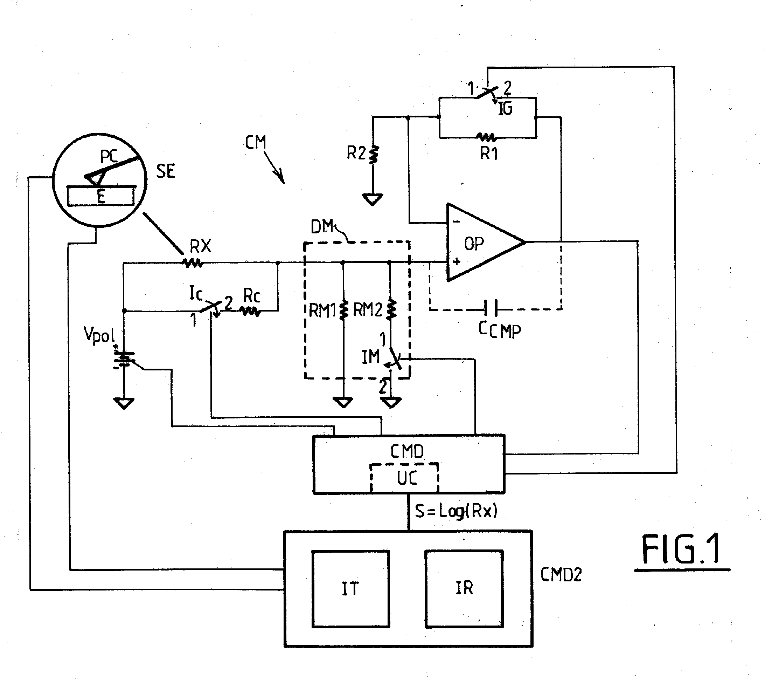

Comme le montre la figure 1, une sonde conductrice PC est mise en contact avec la surface SE, à caractériser, d'un échantillon E. La sonde conductrice peut être une pointe de microscope à force atomique ; en variante, si une résolution spatiale moindre est requise, il peut s'agir d'un stylet de profilomètre ou d'un pion de tribomètre ; dans la suite, on considérera le cas où la sonde est une pointe. La résistance de contact entre l'échantillon et la pointe est indiquée par $R_x$ : il s'agit du paramètre à mesurer.

Un générateur de tension applique une tension de polarisation $V_{pol}$, éventuellement variable, à l'échantillon.

Une résistance $R_c$ de valeur relativement faible (par exemple 100Ω ; plus généralement, inférieure ou égale à la plus faible valeur de $R_x$ que l'on souhaite pouvoir mesurer avec précision) peut être connectée en parallèle à $R_x$ ou déconnectée grâce à un interrupteur $I_c$, réalisé par exemple par un transistor. Comme cela sera expliqué plus loin, la résistance $R_c$ est nécessaire au calibrage du circuit de mesure CM.

La pointe conductrice PC est connectée à la masse par l'intermédiaire d'un dipôle résistif $D_M$, dit « de mesure », caractérisé par une résistance $R_{DM}$. Ainsi, la résistance de contact $R_x$ et le dipôle résistif forment un diviseur de tension. La différence de potentiel $V_s$ aux bornes du dipôle résistif $D_M$ vaut :

$$V_s = \frac{R_{DM}}{R_{DM} + R_x} V_{pol}$$

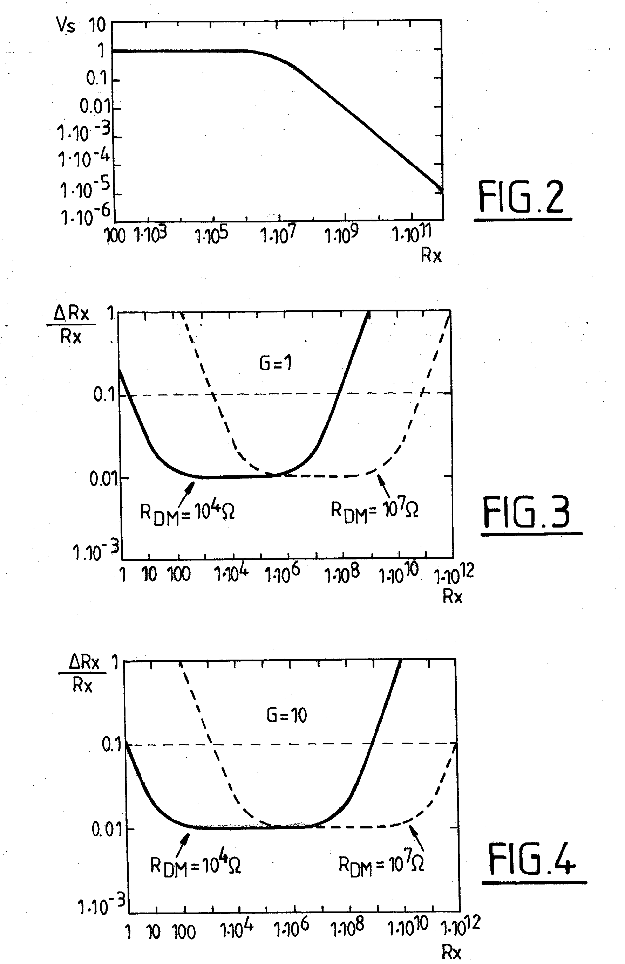

Le graphique de la fonction qui exprime $V_s$ en fonction de $R_x$ est représenté, à l'échelle bi-logarithmique, sur la figure 2 pour $V_{pol}$=1V et $R_{DM}$=10 MΩ. On peut vérifier qu'il s'agit d'une fonction non-linéaire et décroissante, qui permet de réaliser une compression de la variation de $R_x$ permettant d'étendre d'une ou deux décades la gamme des valeurs de $R_x$ mesurables.

On remarque cependant que $V_s$ varie très peu pour des valeurs de $R_x$ inférieures à $10^4$Ω (10 kΩ) ; en effet, une résistance $R_{DM}$ de 10 MΩ est trop élevée pour permettre de mesurer précisément des « faibles » valeurs de $R_x$.

Pour résoudre ce problème, l'invention prévoit l'utilisation d'un dipôle résistif de mesure $D_M$ présentant une résistance variable par paliers. Une manière simple et efficace de réaliser un dipôle résistif variable consiste connecter en parallèle deux résistances, ou plus, de valeurs différentes, reliées à la masse par l'intermédiaire d'interrupteurs respectifs (la résistance de valeur la plus élevée peut être connectée à la masse en permanence). Sur l'exemple de la figure 1, on utilise une résistance $R_{M1}$ de 10 MΩ ($10^7$Ω) connectée en permanence à la masse, et une résistance $R_{M2}$ de 10 kΩ ($10^4$Ω) connectée à la masse par l'intermédiaire d'un interrupteur $I_M$. On comprend aisément que lorsque $I_M$ est ouvert, $R_{DM}$=$R_{M1}$=10 MΩ, tandis que lorsque $I_M$ est fermé $R_{DM} \approx R_{M2}$=10 kΩ.

L'interrupteur $I_M$ peut être réalisé, par exemple, sous la forme d'un JFET. Le changement de valeur de la résistance du dipôle de mesure $D_M$ peut être très rapide ; en effet, les capacités parasites inévitablement présentes disposent toujours d'un chemin leur permettant de se décharger, au pire des cas à travers la résistance $R_{M1}$. La valeur de ces capacités est typiquement comprise entre 1 et 10 pF, ce qui conduit à des constantes de temps de 10 - 100 μs pour $R_{M1}$=10 MΩ.

La tension $V_s$ est lue par un amplificateur à haute impédance d'entrée (impédance d'entrée supérieure à 10 fois la valeur la plus élevée de $R_x$ que l'on souhaite pouvoir mesurer, soit supérieure à $10^{12}$ voire $10^{13}$ Ω dans le mode de réalisation considéré ici) pour ne pas perturber la mesure. Dans l'exemple de la figure 1, cet amplificateur présente un gain variable : on peut voir facilement que lorsque l'interrupteur $I_G$ est fermé, l'amplificateur opérationnel OP est monté en suiveur de tension (gain G=1), tandis que lorsque $I_G$ est ouvert le gain vaut G=$R_1/R_2$ (dans la suite on considérera que, pour $I_G$ ouvert, G=10). Le gain est réglé en fonction de la tension de polarisation $V_{pol}$ et de $R_{DM}$ de manière à éviter une saturation de l'amplificateur et/ou de l'électronique d'acquisition et de traitement placée en aval.

Optionnellement, une capacité $C_{CMP}$ peut être connectée entre la sortie et l'entrée non-inverseuse (« + ») de l'opérationnel pour réaliser une réaction positive qui permet de compenser au moins en partie les capacités parasites à l'entrée de l'amplificateur et augmenter ultérieurement la vitesse d'acquisition des signaux. Il est important de souligner qu'il existe une relation indirecte, mais essentielle, entre dynamique de mesure et vitesse d'acquisition. En effet, la dynamique de mesure peut être étendue vers les hautes résistances en augmentant la valeur maximale qui peut être prise par la résistance $R_{DM}$ du dipôle de mesure. Mais ce faisant on diminue la vitesse d'acquisition, car les capacités parasites doivent se décharger à travers une résistance de valeur élevée. Or, en pratique, il existe une vitesse d'acquisition minimale acceptable, notamment lorsqu'on veut réaliser une image de résistance comprenant plusieurs milliers, voire dizaines de milliers, de points. Au final, la nécessité de trouver un compromis entre vitesse d'acquisition et étendue de la dynamique de mesure impose des limites pratiques à cette dernière.

La tension de sortie de l'amplificateur, égale à G·$V_s$ est fournie, via une carte d'acquisition et conversion analogique/numérique (non représentée), à une unité de calcul UC qui calcule $R_x$ en inversant la fonction de compression

$$R_x = \left( \frac{V_{pol}}{V_s} - 1 \right) R_{DM}$$

de dynamique :  . De préférence, l'unité de calcul ne fournira pas, en tant que signal S de sortie, la valeur $R_x$, mais plutôt son logarithme (notamment décimal) Log($R_x$), ou plus généralement une valeur proportionnelle à ce logarithme (a+b·Log($R_x$)). En effet, les images de résistance sont généralement représentées à l'échelle logarithmique.

De préférence, l'unité de calcul UC sera réalisée sous forme - numérique. Il pourra s'agir d'un circuit numérique dédié ou, plus avantageusement, d'une carte d'acquisition reliée à un ordinateur programmée de manière opportune, ou bien d'une carte de traitement numérique des signaux (« DSP »). Le signal de sortie S peut être analogique ou, plus avantageusement, numérique.

La carte d'acquisition présente une résolution, et donc une dynamique d'entrée, variable. Etant donné qu'un changement résolution est équivalent à une modification d'un gain d'entrée équivalent, on parle de « gain » GC de la carte d'acquisition. Il ne faut pas confondre GC avec G qui, lui, est réellement le gain d'un amplificateur analogique situé en amont de la carte d'acquisition.

La figure 3 montre un graphique (bi-logarithmique) de l'incertitude théorique de mesure $\Delta R_x/R_x$ calculée pour : tolérance des résistances $R_{M1}$ et $R_{M2}$ (et donc de $R_{DM}$): 1% ; $V_{pol}$= 1V ; incertitude relative sur $V_{pol}$ : $\Delta V_{pol} / V_{pol}$=$10^{-5}$ ; incertitude de mesure de $V_s$: $\Delta V_s / V_s$=$10^{-5}$; G=1 (amplificateur opérationnel monté en suiveur de tension). Cette incertitude est donnée par :

$$\frac{\Delta R_x}{R_x} = \frac{\Delta R_{DM}}{R_{DM}} + \left(1 + \frac{R_{DM}}{R_x}\right) \times \frac{\Delta V_{pol}}{V_{pol}} + \frac{(R_x + R_{DM})^2}{R_x \cdot R_{DM}} \times \frac{\Delta V_s}{V_{pol}}$$

La ligne continue se rapporte au cas où la résistance de contact $R_x$ est en série à la résistance de mesure de plus faible valeur, $R_{M2}$=10 kΩ ; la ligne pointillée se rapporte au cas où la résistance de contact $R_x$ est en série à la résistance de mesure de plus grande valeur, $R_{M1}$=10 MΩ. On peut voir que l'incertitude de mesure se maintient inférieure à 10% pour des valeurs de $R_x$ compris entre quelques Ω et $10^{11}$Ω, c'est-à-dire sur presque 11 décades.

Sans la possibilité de changer la résistance du dipôle résistif de mesure, la dynamique de mesure (avec incertitude inférieure à 10%) aurait été d'environ 8 décades - en réalité moins, en raison des effets qui ont été négligés dans cette analyse théorique, en particulier le bruit.

On remarquera que l'incertitude de mesure est minimale pour $R_x$=$R_{DM}$, se maintient presque constante sur 4 décades environ, puis augmente de manière symétrique pour des grandes et petites valeurs de $R_x$. Par conséquent, plus grande est la résistance maximale que l'on souhaite pouvoir mesurer avec précision, plus grande doit être la valeur maximale de $R_{DM}$, sachant que - comme expliqué plus haut - l'utilisation d'une résistance de mesure élevée impose une pénalité en termes de vitesse d'acquisition. Dans le cas de l'exemple décrit ici, un temps d'acquisition par point d'environ 0,5 ms a été démontré.

La figure 4 montre un graphique de l'incertitude de mesure dans le cas où G=10, tous les autres paramètres demeurant inchangés. On peut voir que cela permet de mesurer, avec une incertitude inférieure ou égale à 10%, des résistances pouvant atteindre $10^{12}$Ω. La dynamique de mesure couvre donc, dans ce cas, 12 décades. L'effet d'un facteur d'amplification G supérieur à 1 est d'autant plus bénéfique que la tension de polarisation est faible (ce qui est parfois imposé par les caractéristiques de l'échantillon). Des gains supérieurs à 10 peuvent aussi être utilisés, pour la mesure de hautes valeurs de résistances de surface $R_x$. Cependant, l'augmentation du gain a un effet défavorable sur le bruit affectant le signal de mesure. Il n'est donc pas possible d'augmenter sans limites la dynamique de mesure en agissant uniquement sur le gain.

Le circuit de mesure CM, décrit ci-dessus, est piloté par un dispositif de commande CMD, qui peut être en particulier un ordinateur ou une carte de commande à microprocesseur. Ce dispositif pilote l'ouverture et la fermeture des interrupteurs $I_c$, $I_M$ et $I_G$ et, le cas échéant, règle la valeur de la tension de polarisation $V_{pol}$ (comme cela sera expliqué plus loin) et le gain GC de la carte d'acquisition. L'unité de calcul UC peut être intégrée dans le dispositif de commande CMD, ou constituer une unité séparée.

Dans le mode de réalisation de l'invention considéré ici, l'appareil constitué par le circuit de mesure, la source de polarisation et le dispositif de commande CMD est associé à un microscope à force atomique dont la pointe PC sert de sonde conductrice pour la mesure de la résistance locale de la surface de l'échantillon. Un deuxième dispositif de commande CMD2 pilote le déplacement de la pointe conductrice PC sur la surface SE (le plus souvent, en déplaçant l'échantillon E au moyen d'un actionneur piézoélectrique non représenté), acquiert les informations topographiques en provenance de ladite pointe conductrice ainsi que le signal S issu de l'unité de calcul UC, et génère point par point une image topographique IT et une image de résistance IR de la surface SE.

En variante, les fonctionnalités des dispositifs de commande CMD et CMD2 peuvent être réalisées par un seul et unique dispositif de commande.

Selon différents modes de réalisation, l'appareil de l'invention peut être couplé par exemple à un profilomètre, à un tribomètre, ou bien être réalisé sous la forme d'un dispositif indépendant.

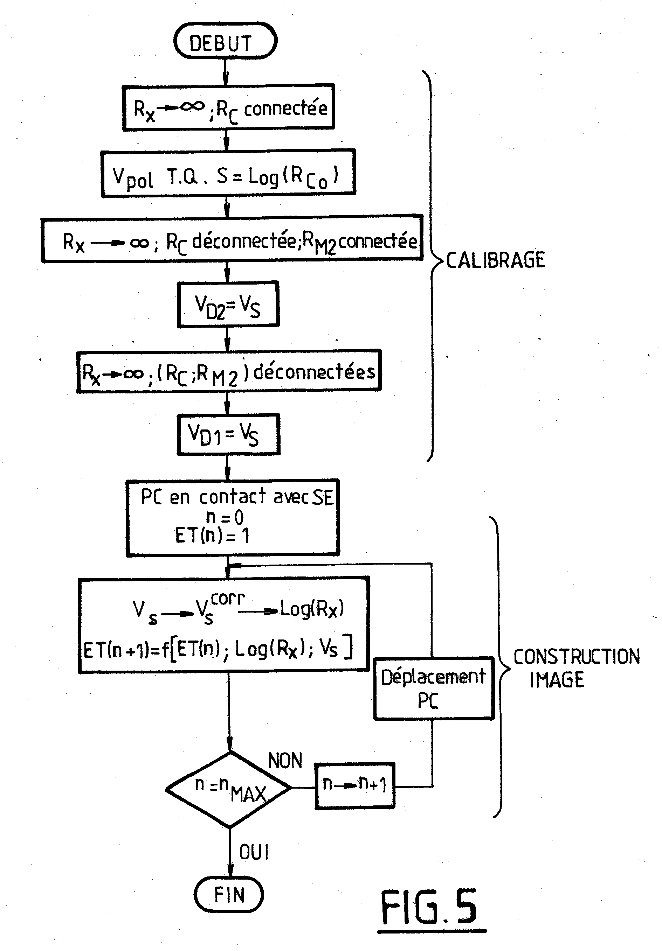

La figure 5 montre un organigramme d'un programme de pilotage du circuit de mesure pouvant être exécuté par le dispositif de commande CMD. Ce programme comporte une séquence de calibrage suivie par une séquence d'acquisition des mesures et de construction d'une image de résistance.

Préalablement au calibrage, on détermine la tension de polarisation $V_{pol}$ (dont la valeur pourra être légèrement modifiée afin de réaliser le calibrage), le gain équivalent GC de la carte d'acquisition et le gain G de l'amplificateur d'entrée. Ce dernier paramètre est fixé manuellement, généralement en fonction de $V_{pol}$ afin d'éviter tout risque de saturation de la carte d'acquisition. Par exemple, on peut poser G=1 pour $V_{pol}$>1V, G=10 autrement.

La séquence de calibrage s'effectue en maintenant la pointe conductrice PC à l'écart de toute surface (ou en contact avec une surface isolante), de telle sorte que $R_x \to \infty$.

Dans une première étape de calibrage, l'interrupteur $I_C$ est fermé, de telle sorte qu'une résistance étalon $R_C$ (100Ω) soit connectée et joue le rôle de la résistance $R_x$ à mesurer, ce qui permet le calibrage du circuit de mesure pour les basses valeurs de cette résistance. Comme $R_C$ est connue, la valeur attendue du signal de sortie S l'est aussi ; par exemple, si S=Log($R_x$), sa valeur attendue lors de cette étape de calibrage est 2 (nombre pur dans le cas d'un signal numérique ; 2V dans le cas d'un signal analogique). En général, la valeur réelle de S sera différente de cette valeur attendue. Il sera cependant possible d'agir sur un paramètre de calibrage du circuit de mesure pour que S(réel)=S(attendu). De préférence, le paramètre de calibrage est la tension de polarisation $V_{pol}$. En variante, il peut s'agir d'un ou plusieurs paramètres d'une fonction de linéarisation, ou des valeurs contenues dans une table de correspondance.

Cette technique très simple permet de régler efficacement les décalages observés sur les mesures de résistances basses en faisant varier $V_{pol}$ de quelques pourcents seulement, voire moins. L'ajustement de la tension de polarisation pour compenser les erreurs peut s'effectuer grâce à une boucle de réaction de type Proportionnel-Intégral. Par contre, cette procédure de compensation par variation de la polarisation peut introduire des erreurs importantes si la tension de polarisation est trop faible, par exemple inférieure à 10 mV.

Dans une deuxième étape de calibrage on déconnecte $R_C$ tout en maintenant $R_x \to \infty$, et on ferme l'interrupteur $I_M$ de manière à connecter $R_{M2}$ à l'entrée de l'amplificateur OP. Il s'agit de mesurer le décalage de tension (« offset ») $V_{D1}$ présent à la sortie dudit amplificateur pour $R_{DM}=R_{M2}$.

Puis on ouvre l'interrupteur $I_M$ et on mesure le décalage $V_{D2}$ présent à la sortie de l'amplificateur OP pour $R_{D\Omega M}=R_{M1}$.

S'il y a plus que deux résistances de mesure, on répète ces étapes autant de fois que nécessaire.

Une fois terminée la séquence de calibrage, on peut commencer l'acquisition des mesures de résistance. La pointe PC est mise en contact avec la surface SE et un compteur n est initialisé à zéro.

Au cours de la séquence de mesure, le circuit de mesure se trouve dans l'un des trois états ET suivants :

$$ET=1 : R_{DM}=R_{M2}=10k\Omega ; GC=1 ;$$

$$ET=2 : R_{DM}=R_{M2}=10k\Omega ; GC=8 ;$$

$$ET=3 : R_{DM}=R_{M1}=10M\Omega ; GC=8.$$

(le cas: $R_{DM}=R_{M1}=10M\Omega$ ; GC=1 est possible en principe mais présente peu d'intérêt). On supposera qu'au début de la séquence ET=1, mais ce choix est arbitraire.

L'unité de calcul UC lit la tension de G·$V_s$ à la sortie de l'amplificateur, la divise par le gain G, la corrige par soustraction du décalage ($V_{D1}$ ou $V_{D2}$, en fonction de l'état ET du circuit de mesure), et utilise la valeur corrigée $V_s^{corr}$ pour calculer le signal de sortie S=Log($R_x$).

Puis, le dispositif de commande décide quel sera l'état du circuit à l'étape n+1 de la séquence, en fonction de l'état à l'étape n, de la valeur mesurée de Log($R_x$) et, éventuellement, de la tension mesurée $V_s$ (une faible valeur de $V_s$ rendant souhaitable l'utilisation d'un gain de la carte d'acquisition GC élevé). On peut écrire : ET(n+1)=f[ET(n) ; Log($R_x$) ; $V_s$].

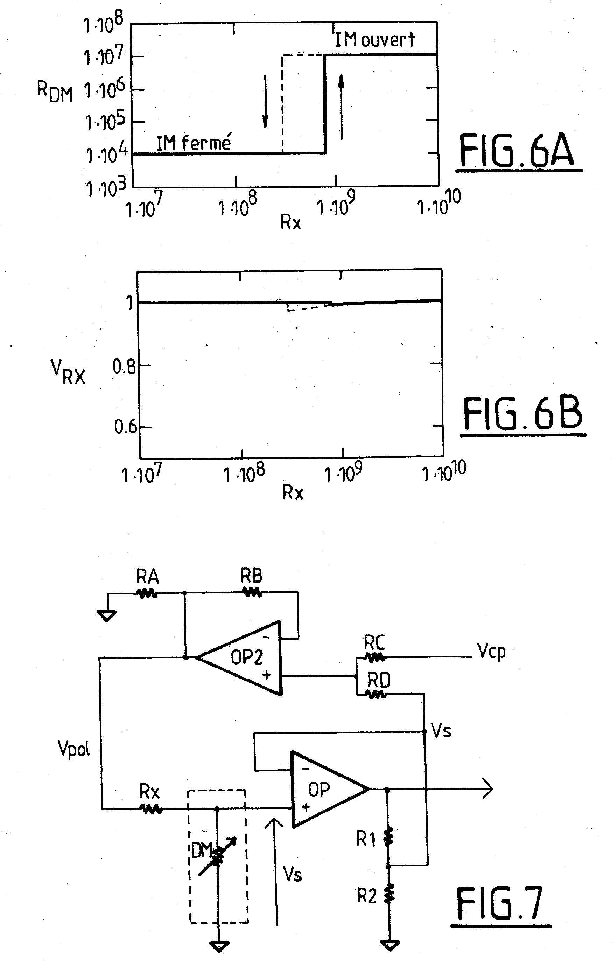

En réalité, « f » n'est pas une fonction au sens mathématique du terme, mais une loi de commande à hystérésis. En laissant provisoirement de côté la dépendance de $V_s$, cette loi de commande est représentée sur la figure 6A.

On suppose que $R_x$ a initialement une valeur « basse », inférieure à 10kΩ. Dans ces conditions, l'interrupteur IM doit être fermé, afin que $R_{DM}=R_{M2}=10k\Omega$. Puis $R_x$ commence à augmenter. L'interrupteur IM reste fermé jusqu'à ce que $R_x$ dépasse la valeur $R_{Th1}$= 600MΩ ; à ce point il s'ouvre, afin que $R_{DM}=R_{M2}=10M\Omega$. Ensuite $R_x$ commence à diminuer. L'interrupteur IG reste ouvert tant que $R_x$ ne descend pas au-dessous de la valeur $R_{T2h}$= 300MΩ, puis il se ferme. Il y a donc hystérésis, comme montré par la figure 6A. On remarquera que l'incertitude de mesure dépend très faiblement de RDM pour Rx compris entre RM2 et RM1. La figure 6B montre que la commutation de résistance n'induit qu'une très faible variation de la tension $V_{RX}$ aux bornes de la résistance de contact, et donc de la tension de mesure $V_s$.

Si le compteur n a atteint la valeur maximale $n_{MAX}$, indiquant qu'une image complète a été acquise, le programme s'arrête. Sinon, n est incrémenté d'une unité, la pointe PC est déplacée par rapport à la surface SE (en réalité, c'est plutôt l'échantillon qui se déplace, tandis que la pointe reste immobile ; mais ce qui compte est le déplacement relatif) et la séquence de mesure recommence de manière à permettre l'acquisition d'une valeur de résistance locale de ladite surface en correspondance du nouveau point de contact de la pointe PC. En variante, le programme peut tourner en continu : dans ce cas, le compteur n n'est pas nécessaire.

En variante, il est possible de faire varier la tension de polarisation $V_{pol}$ au cours de chaque acquisition, pour mettre en évidence et caractériser une non-linéarité éventuelle de la résistance $R_x$.

Un inconvénient du circuit de mesure de la figure 1 est que la différence de potentiel entre la surface et la pointe conductrice n'est pas complètement constante, mais dépend de $R_x$. Cela peut être de nature à fausser le résultat des mesures, si la résistance $R_x$ est non-linéaire. Pour ces raisons, il peut être intéressant d'utiliser une variante du circuit de mesure, illustrée sur la figure 7, permettant de maintenir constante, et égale à une consigne $V_{CP}$ provenant du dispositif de commande CMD, la différence de potentiel entre l'échantillon et la pointe (c'est-à-dire la chute de tension $V_{RX}$ aux bornes de $R_x$). Dans ces conditions, $V_{pol}$ n'est plus constante, et l'unité de calcul UC doit en tenir compte pour déterminer correctement $Log(R_x)$.

Dans ce mode de réalisation de l'appareil de l'invention, la source de tension de polarisation est remplacée par un amplificateur opérationnel OP2 monté en configuration non-inverseuse avec un gain égal à 2 ($R_A=R_B$). Les résistances $R_C$, $R_D$ à l'entrée non-inverseuse de OP2 réalisent un montage additionneur. On peut vérifier que si $R_A=R_B=R_C=R_D$, alors $V_{pol}=V_{CP}+V_s$. Or, OP impose la relation suivante :

$$V_{pol} = \frac{V_{CP}\left(R_x + R_{DM}\right)}{R_x} = V_{CP}\left(1 + \frac{R_{DM}}{R_x}\right).$$

$$R_x = \frac{V_{CP}R_{DM}}{V_S}$$

Dans ces conditions, $R_x$ est donnée par :

$$G = 1 + \frac{R_1}{R_2}$$

La tension de sortie de l'amplificateur OP vaut $GV_s$, où le gain G est égal à . Comme dans le montage de la figure 1, ce gain peut être rendu variable en prévoyant un interrupteur en parallèle à la résistance $R_1$.


## Revendications

**1.** Appareil de mesure de la résistance électrique locale d'une surface, comprenant :

- Une sonde conductrice (PC) susceptible d'entrer en contact avec une surface (SE) d'un échantillon (E) à caractériser ;
- Un circuit de mesure (CM) connecté à la sonde conductrice, pour générer un signal (S) représentatif d'une résistance de contact (Rx) entre ladite sonde conductrice et ladite surface de l'échantillon;
- Une source de tension continue pour appliquer une tension de polarisation (Vpol); et
- Un dispositif de commande (CMD) relié audit circuit de mesure (CM) pour le piloter ; où ledit circuit de mesure comprend un dipôle résistif de mesure (DM), présentant une résistance variable par paliers (RDM), connecté entre ladite sonde conductrice (PC) et une masse du circuit, de sorte que la résistance de contact et le dipôle résistif de mesure (DM) forment un diviseur de tension, ledit dipôle résistif de mesure comprenant une pluralité de résistances de mesure (RM1, RM2) de valeurs décroissantes, dont au moins une peut être connectée ou déconnectée sélectivement entre ladite sonde conductrice (PC) et la masse ; où la source de tension est configurée pour appliquer la tension de polarisation (Vpol) audit échantillon (E) où l'appareil comporte en outre une unité de calcul (UC) pour générer ledit signal représentatif de la résistance de contact (Rx) entre ladite sonde conductrice (PC) et ladite surface de l'échantillon (E) en fonction d'une tension (Vs) qui apparaît aux bornes dudit dipôle résistif de mesure (DM) du fait de l'application de ladite tension de polarisation (Vpol); Et en ce que ledit dispositif de commande (CMD) est adapté pour modifier la valeur de résistance dudit dipôle résistif (DM), selon une loi de commande avec hystérésis, en fonction d'une valeur mesurée préalablement de ladite résistance de contact (Rx), de manière à adapter la gamme de mesure de l'appareil à la résistance à mesurer.

**2.** Appareil selon l'une des revendications précédentes comprenant également une résistance de calibrage (RC) pouvant être connectée ou déconnectée en parallèle à l'ensemble constitué par ledit échantillon (E) et ladite sonde conductrice (PC).

**3.** Appareil selon la revendication 2 dans lequel ladite résistance de calibrage (RC) présente une résistance inférieure d'au moins un facteur 10 à la valeur minimale de résistance dudit dipôle résistif de mesure (DM).

**4.** Appareil selon la revendication 2 ou la revendication 3 dans lequel ledit dispositif de commande (CMD) est adapté pour :

   - Connecter ladite résistance de calibrage (RC) en parallèle de ladite sonde conductrice (PC), maintenue à l'écart de toute surface conductrice, et mesurer la différence de potentiel aux bornes du dipôle résistif de mesure (DM) ;
   - Déconnecter ladite résistance de calibrage (RC) alors que ladite sonde conductrice (PC) est toujours maintenue à l'écart de toute surface conductrice, et mesurer la différence de potentiel aux bornes du dipôle résistif de mesure (DM) pour toutes les valeurs de résistance de ce dernier ; et
   - Calibrer ledit circuit de mesure (CM) à l'aide des valeurs de différence de potentiel mesurées.

**5.** Appareil selon l'une des revendications précédentes dans lequel ladite unité de calcul (UC) est adaptée pour calculer le logarithme de ladite résistance de contact (RX) en fonction de la tension aux bornes (VS) du dipôle résistif de mesure (DM).

**6.** Appareil selon l'une des revendications précédentes dans lequel ladite source de tension continue est une source de tension adjustable (OP2).

**7.** Appareil selon la revendication 6 dans lequel ledit dispositif de commande (CMD) est adapté pour piloter ladite source de tension continue de manière à maintenir constante la différence de potentiel (VCP) entre ledit échantillon (E) et ladite sonde conductrice (PC), indépendamment de la valeur de ladite résistance de contact (RX).

**8.** Appareil selon l'une des revendications précédentes dans lequel la différence de potentiel (VX) aux bornes du dipôle résistif de mesure (DM) est lue par un amplificateur (OP) à haute impédance d'entrée présentant une réaction positive à travers un condensateur (CCMP), de manière à compenser des capacités parasites du circuit de mesure.

**9.** Appareil selon l'une des revendications précédentes dans lequel l'unité de calcul (UC) est comprise dans le circuit de mesure (CM) ou intégrée dans le dispositif de commande (CMD).

**10.** Appareil selon l'une des revendications précédentes **caractérisé en ce que** la sonde conductrice (PC) est choisie parmi une pointe de microscope à force atomique, un stylet de profilomètre et d'un pion de tribomètre.

**11.** Appareil selon la revendication 9 comportant également un deuxième dispositif de pilotage pour piloter un actionneur induisant un déplacement de la sonde conductrice (PC) par rapport à la surface de l'échantillon (E), et pour recevoir dudit circuit de mesure (CM) ledit signal représentatif d'une résistance de contact (RX), de manière à acquérir simultanément une image topographique (IT) et une image de résistance locale (IR) de ladite surface.

**Patentansprüche**

**1.** Vorrichtung zum Messen des lokalen elektrischen Widerstands einer Oberfläche, umfassend:

   - eine leitfähige Sonde (PC), die dafür geeignet ist, mit einer Oberfläche (SE) einer zu bestimmenden Probe (E) in Kontakt zu treten;
   - eine Messschaltung (CM), die an die leitfähige Sonde angeschlossen ist, um ein Signal (S) zu erzeugen, das für einen Berührungswiderstand (Rx) zwischen der leitfähigen Sonde und der Oberfläche der Probe steht;
   - eine Gleichspannungsquelle zum Anlegen einer Polarisationsspannung (Vpol); und

   eine Steuereinrichtung (CMD), die mit der Messschaltung (CM) verbunden ist, um diese zu steuern;
   worin die Messschaltung einen widerstandsfähigen Messdipol (DM) umfasst, der einen schrittweisen Regelwiderstand (RDM) aufweist und derart zwischen der leitfähigen Sonde (PC) und einer Schaltungsmasse angeschlossen ist, dass der Berührungswiderstand und der widerstandsfähige Messdipol (DM) einen Spannungsteiler bilden, wobei der widerstandsfähige Messdipol eine Vielzahl von Messwiderständen (RM1, RM2) mit abnehmenden Werten umfasst, von denen mindestens einer selektiv zwischen der leitfähigen Sonde (PC) und der Masse angeschlossen oder getrennt werden kann;

worin die Spannungsquelle dafür konfiguriert ist, die Polarisationsspannung (Vpol) an die Probe (E) anzulegen,

worin die Vorrichtung ferner ein Rechenwerk (UC) aufweist, um das Signal, das für den Berührungswiderstand (Rx) zwischen der leitfähigen Sonde (PC) und der Oberfläche der Probe (E) steht, in Abhängigkeit von einer Spannung (Vs), die an den Polköpfen des widerstandsfähigen Messdipols (DM) durch das Anlegen der Polarisationsspannung (Vpol) vorliegt, zu erzeugen;

und dadurch, dass die Steuereinrichtung (CMD) dazu geeignet ist, den Widerstandswert des widerstandsfähigen Dipols (DM) gemäß einem Steuerungsgesetz mit Hysterese in Abhängigkeit von einem vorher gemessenen Wert des Berührungswiderstands (Rx) derart zu modifizieren, dass der Messbereich der Vorrichtung an den zu messenden Widerstand angepasst wird.

2. Vorrichtung nach einem der vorhergehenden Ansprüche, ebenfalls umfassend einen Kalibrierungswiderstand (RC), der parallel zu der aus der Probe (E) und der leitfähigen Sonde (PC) gebildeten Einheit angeschlossen oder getrennt werden kann.

3. Vorrichtung nach Anspruch 2, wobei der Kalibrierungswiderstand (RC) einen Widerstand darstellt, der um mindestens einen Faktor 10 kleiner als der minimale Widerstandswert des widerstandsfähigen Messdipols (DM) ist.

4. Vorrichtung nach Anspruch 2 oder Anspruch 3, wobei die Steuereinrichtung (CMD) für Folgendes geeignet ist:

 - Anschließen des Kalibrierungswiderstands (RC) parallel zu der leitfähigen Sonde (PC), die in Abstand zu jeglicher leitfähiger Oberfläche gehalten wird, und Messen der Potentialdifferenz an den Polköpfen des widerstandsfähigen Messdipols (DM);
 - Trennen des Kalibrierungswiderstands (RC), während die leitfähige Sonde (PC) immer noch in Abstand zu jeglicher leitfähiger Oberfläche gehalten wird, und Messen der Potentialdifferenz an den Polköpfen des widerstandsfähigen Messdipols (DM) für alle Widerstandswerte von letzterem; und
 - Kalibrieren der Messschaltung (CM) mithilfe der gemessenen Werte der Potentialdifferenz.

5. Vorrichtung nach einem der vorhergehenden Ansprüche, wobei das Rechenwerk (UC) dafür geeignet ist, den Logarithmus des Berührungswiderstands (RX) in Abhängigkeit von der Spannung an den Polköpfen (VS) des widerstandsfähigen Messdipols (DM) zu berechnen.

6. Vorrichtung nach einem der vorhergehenden Ansprüche, wobei die Gleichspannungsquelle eine einstellbare Spannungsquelle (OP2) ist.

7. Vorrichtung nach Anspruch 6, wobei die Steuereinrichtung (CMD) dafür geeignet ist, die Gleichspannungsquelle derart zu steuern, dass die Potentialdifferenz (VCP) zwischen der Probe (E) und der leitfähigen Sonde (PC) unabhängig von dem Wert des Berührungswiderstands (RX) konstant gehalten wird.

8. Vorrichtung nach einem der vorhergehenden Ansprüche, wobei die Potentialdifferenz (VX) an den Polköpfen des widerstandsfähigen Messdipols (DM) durch einen Verstärker (OP) mit hoher Eingangsimpedanz gelesen wird, der eine positive Reaktion über einen Kondensator (CCMP) derart zeigt, dass parasitäre Kapazitäten der Messschaltung kompensiert werden.

9. Vorrichtung nach einem der vorhergehenden Ansprüche, wobei das Rechenwerk (UC) in der Messschaltung (CM) enthalten oder in der Steuereinrichtung (CMD) integriert ist.

10. Vorrichtung nach einem der vorhergehenden Ansprüche, **dadurch gekennzeichnet, dass** die leitfähige Sonde (PC) ausgewählt ist aus einer Atomkraftmikroskopspitze, einem Profilometersstift und einem Tribometer-Pion.

11. Vorrichtung nach Anspruch 9, ebenfalls umfassend eine zweite Steuereinrichtung zum Steuern einer Betätigungsvorrichtung, die eine Verschiebung der leitfähigen Sonde (PC) in Bezug auf die Oberfläche der Probe (E) induziert, und zum Empfangen des Signals, das für einen Berührungswiderstand (RX) steht, von der Messschaltung (CM) derart, dass gleichzeitig ein topographisches Bild (IT) und ein Bild des lokalen Widerstands (IR) der Oberfläche erfasst werden.

**Claims**

1. An apparatus for measuring the local electrical resistance of a surface, the apparatus comprising:

   - a conductive probe (PC) suitable for coming into contact with a surface (SE) of a sample (E) to be characterised;
   - a measurement circuit (CM) connected to the conductive probe in order to generate a signal (S) representative of a contact resistor (Rx) between said conductive probe and said surface of the sample;
   - a DC voltage source for applying a bias voltage (Vpol); and
   - a control device (CMD) connected to the measurement circuit (CM) for controlling said measurement circuit;

   the measurement circuit comprising a resistive measurement dipole (DM) having stepwise variable resistor (RDM) and connected between said conductive probe (PC) and a ground of the circuit, such that the contact resistor and the resistive measurement dipole (DM) form a voltage divider, said resistive measurement dipole comprising a plurality of measurement resistors (RM1, RM2) of decreasing resistances, at least one of which may be connected or disconnected selectively between said conductive probe (PC) and ground; wherein the DC voltage source is configured to apply the bias voltage (Vpol) to said sample (E); wherein the device further has a calculation unit (UC) for generating said signal representative of the contact resistor (Rx) between said conductive probe (PC) and said surface of the sample (E) as a function of a voltage (Vs) which appears across the terminals of said measurement resistive dipole (DM) as a consequence of applying said bias voltage (Vpol); and in that said control device (CMD) is adapted to modify the resistance value of said resistive dipole (DM) in accordance with a control law with hysteresis as a function of a previously measured value of said contact resistor (Rx) so as to match the measurement range of the apparatus to the resistor to be measured.

2. The apparatus according to any of the preceding claims, comprising additionally a calibration resistor (RC) connectable or disconnectable in parallel with the assembly constituted by said sample (E) and said conductive probe (PC).

3. The apparatus according to claim 2, wherein said calibration resistor (RC) presents a resistance that is less than the minimum resistance value of said resistive measurement dipole by a factor of at least 10.

4. The apparatus according to claim 2 or claim 3, wherein said control device (CMD) is adapted to:

   - connect said calibration resistor (RC) in parallel with said conductive probe (PC) which is being kept away from any conductive surface, and measure the potential difference across the terminals of the resistive measurement dipole (DM);
   - disconnect said calibration resistor (RC) while said conductive probe (PC) continues to be kept away from any conductive surface, and measure the potential difference across the terminals of the resistive measurement dipole for all resistance values of the latter; and
   - calibrate said measurement circuit (CM) with the help of the measured potential difference values.

5. The apparatus according to any of the preceding claims, wherein said calculation unit (UC) is adapted to calculate the logarithm of said contact resistor (RX) as a function of the voltage across the terminals (VS) of the resistive measurement dipole (DM).

6. The apparatus according to any of the preceding claims, wherein said DC voltage source is an adjustable voltage source (OP2).

7. The apparatus according to claim 6, wherein said control device (CMD) is adapted to control said DC voltage source so as to keep the potential difference (VCP) between said sample (E) and said conductive probe (PC) constant independently of the value of said contact resistor (RX).

8. The apparatus according to any of the preceding claims, wherein the potential difference (VX) across the terminals of the resistive measurement dipole (DM) is read by an amplifier (OP) having high input impedance, which presents positive reaction via a capacitor (CCMP) so as to compensate for the stray capacitance of the measurement circuit.

9. The apparatus according to any of the preceding claims, wherein the calculation unit (UC) is comprised in the measurement circuit (CM) or integrated in the control device (CMD).

10. The apparatus according to any of the preceding claims, **characterised in that** the conductive probe (PC) is selected from an atomic force microscopic tip, a profilometer stylus, and a tribometer pin.

11. The apparatus according to claim 9, also comprising a second control device for controlling an actuator inducing a displacement of the conductive probe (PC) relative to the surface of the sample (E), and to receive from said measuring circuit (CM) said signal representative of a contact resistor (RX), so as to simultaneously acquire a topographic image (IT) and a local resistance image (IR) of said surface.

FIG.1

FIG.2

FIG.3

FIG.4

FIG. 5

FIG.6A

FIG.6B

FIG.7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• US 6871559 B

**Littérature non-brevet citée dans la description**

• **J.T. DICKINSON et al.** *Rev. Sci. Instrum.,* 1995, vol. 66 (7), 3802

• **F. HOUZÉ et al.** *Appl. Phys. Lett.,* 1975, vol. 69 (13